Europäisches Patentamt

European Patent Office

Office européen des brevets

(11) Veröffentlichungsnummer: **0 278 413**
**A2**

## EUROPÄISCHE PATENTANMELDUNG

(21) Anmeldenummer: **88101661.2**

(22) Anmeldetag: **05.02.88**

(51) Int. Cl.⁴: **H01L 21/60 , H01L 21/48**

(30) Priorität: **11.02.87 DE 3704200**

(43) Veröffentlichungstag der Anmeldung:
**17.08.88 Patentblatt 88/33**

(84) Benannte Vertragsstaaten:
**DE ES FR GB IT**

(71) Anmelder: **BBC Brown Boveri Aktiengesellschaft**
**Kallstadter Strasse 1**
**D-6800 Mannheim 31(DE)**

(72) Erfinder: **Okstajner, Tomislav, Dipl.-Ing.**
**Korngasse 23**
**D-6915 Dossenheim(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**D-6800 Mannheim 1(DE)**

(54) Verfahren zur Herstellung einer Verbindung zwischen einem Bonddraht und einer Kontaktfläche bei hybriden Dickschicht-Schaltkreisen.

(57) Um Korrosionsvorgänge bei den Kontaktverbindungsstellen im Inneren von hybriden Schaltkreisen bei Temperaturen um/oder über ca. 200 °C zu vermeiden, wird eine Diffusionssperrschicht (5) auf die Kontaktfläche, (Verbindungsstelle 2) aufgebracht. Diese Sperrschicht 5 kann durch Aufdampfen über Masken (4) oder durch Verwendung eines speziell ummantelten Bonddrahtes (8, 9) auf die Kontaktfläche (2) aufgebracht werden. Die Kontaktfläche entsteht bei der Verbindung eines Bonddrahtes (7, 8) mit einer Leiterbahn (2) oder einem Halbleiterchip (3).

EP 0 278 413 A2

**Verfahren zur Herstellung einer Verbindung zwischen einem Bonddraht und einer Kontaktfläche bei hybriden Dickschicht-Schaltkreisen**

Die Erfindung bezieht sich auf ein Verfahren zur Herstellung einer Verbindung zwischen einem Bonddraht und einer Kontaktfläche bei hybriden Dickschicht-Schaltkreisen. Die Erfindung liegt auf dem Gebiet der Werkstofftechnologie und findet Anwendung bei der Fertigung elektronischer Schaltkreise.

Elektronische Bauteile werden oft zu kompakten Formen zusammengesetzt. Hierzu kann beispielsweise die Dünnfilm-oder die Dickfilmtechnik eingesetzt werden. Bei Dünnfilmschaltkreisen werden auf einen Träger dünne Schichten aufgedampft (aufgesputtert). Bei Dickfilmschaltkreisen werden Pasten verwendet, die unter hohen Temperaturen eingebrannt werden.

Die auf hybriden Dickfilmschaltkreisen eingesetzten Bauelemente (Halbleiter-Chips, Kondensatoren usw.) müssen entsprechend dem Schaltungslayout untereinander verbunden werden, was entweder durch Löten oder Schweißen (Fachausdruck: Bonden) realisiert wird. Dabei müssen die Chips über Bonddrähte (Aluminium, Gold) mit den aus z. B. Goldpaste hergestellten Leiterbahnen gebondet werden. Bei hohen Temperaturen entstehen dabei Schwierigkeiten, weil durch den sogenannten "Kirkendall-Effekt" eine Versprödung (Verarmung) der intermetallischen Phase auftritt.

Bei der Verbindung eines Aluminium-Drahtes mit einer Leiterbahn (aus Gold) tritt der nicht beherrschbare physikalische Effekt auf, daß bei Temperaturen über 150 °C die metallische Verbindung mechanisch nicht mehr haftet und elektrisch nicht mehr einwandfrei ist. Dieser unerwünschte Korrosionseffekt (bei hohen Temperaturen diffundieren die Metalle ineinander) kann beim Einsatz eines hybriden Schaltkreises unter hohen Temperaturbedingungen auftreten und führt dann zum kompletten Ausfall der gesamten Schaltung. Durch die Verwendung anderer Materialien kann dieser Korrosionseffekt zwar verlangsamt aber nicht verhindert werden.

Seit Jahren gibt es Vorschläge zur Lösung des Korrosionsproblems von Bondverbindungen in hybriden Schaltkreisen. Alle bisher in der Literatur beschriebenen Verfahren versuchen dieses Problem durch einen komplizierten Schichtaufbau auf der Halbleiterseite zu lösen. Insbesondere die US-PS 35 85 461 und US-PS 41 76 443 zeigen den bedeutenden zusätzlichen Aufwand bei der Herstellung solcher Halbleiterchips. Der Aufbau einer Produktionsanlage für derartige Chips lohnt sich nur dann, wenn die Abnahme sehr großer Stückzahlen gesichert ist. Bei Einzelfertigung bzw. geringen Stückzahlen lohnt sich aber nicht der Aufbau einer teueren Produktionsanlage. Trotzdem muß auch hier der Korrosionsschutz bei den Bondverbindungen gegeben sein.

Es ist deshalb Aufgabe der Erfindung, bei Anwendungen mit kleinem Stückzahlbedarf den Korrosionsschutz von der teueren Halbleiterseite auf die billige Seite der Verdrahtung zur Substratleiterbahn zu verlegen.

Erfindungsgemäß wird dies durch die Merkmale des Patentanspruchs 1 erzielt. Ausgestaltung und vorteilhafte Weiterentwicklungen sind aus den Unteransprüchen ersichtlich.

Die Lösung des Korrosionsproblems besteht erfindungsgemäß darin, daß auf der Halbleiterseite die herkömmliche Metallisierungstechnik weiterhin benutzt werden kann und bei der Bondverbindung zur Substratleiterbahn, also der Verbindung vom Chip zur Leiterbahn, ein neues, einfaches und werkstofftechnologisches Verfahren zum Einsatz kommt. Das erfindungsgemäße Verfahren zeigt erstmals einen wirtschaftlichen Weg für Anwendungen mit kleinem Stückzahlbedarf auf. Gerade durch die Verwendung eines mit einer Sperrschicht ummantelten Bonddrahtes wird die komplizierte Herstellung einer Diffusionssperrschicht auf dem Halbleiterchip umgangen.

Durch das erfindungsgemäße Verfahren wird die Ausfallquote bei hybriden Schaltkreisen stark vermindert. Bisherige Schaltkreise waren in ihrem Einsatz durch die schlechte Temperaturanpassung großen Beschränkungen unterworfen und für viele Fälle (bei Temperaturen über 200 °C) überhaupt nicht einsatzfähig. Durch die Anwendung des neuen Verfahrens können Geräte mit langer Lebensdauer, hoher Qualität und geringer Ausfallrate hergestellt werden. Weitere Vorteile sind aus der nachfolgenden Beschreibung der Ausführungsbeispiele ersichtlich.

Verfahren gemäß der Erfindung werden nachstehend anhand der Zeichnungen näher erläutert.

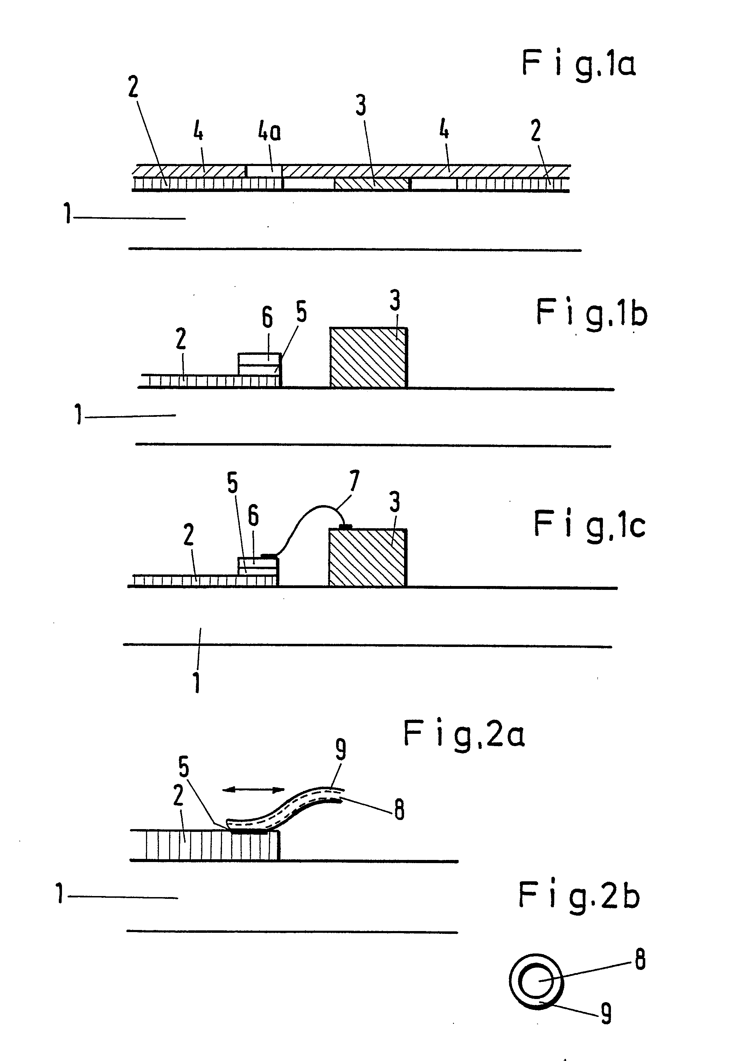

Die Figuren 1a bis 1c zeigen dabei ein Verfahren unter Verwendung einer Maske, während die Figuren 2a, 2b den Einsatz eines speziellen Bonddrahtes zeigen.

Die bei Temperaturen von ca. 200 °C auftretenden Zerstörungen von hybriden Schaltkreisen werden durch die Bildung sogenannter intermetallischer Phasen verursacht. Insbesondere bei der Anwendung von Golddraht besteht diese intermetallische Korrosion auf der Halbleiterseite, d. h., an der Anschlußstelle Golddraht und mit Aluminium hergestellte Anschlußstelle auf dem Chip. Bei der Anwendung eines Aluminiumdrahtes entstehen die intermetallischen Phasen auf der Substratseite.

In den vorliegenden Ausführungsbeispielen wird von einem Aluminiumdraht und einer Gold-Leiterbahn auf der Substratseite ausgegangen. Dieselben Korrosionsvorgänge treten natürlich bei mit Aluminium hergestellter Anschlußstelle auf dem Chip und Golddraht auf.

Figur 1a zeigt einen einfachen Hybridbaustein mit einem Chip und einer Leiterbahn. Das Trägermaterial ist als Keramiksubstrat 1 ausgebildet. Auf diesem Substrat sind eine Leiterbahn 2 und eine Plazierungsstelle für einen Halbleiter-Chip 3 angeordnet. Die Leiterbahn 2 besteht aus Gold und die Kontaktierungsstellen des Chips 3 aus Aluminium. Ein Aluminiumdraht 7 (Bonddraht) gemäß Figur 1c soll die Verbindung zwischen Chip 3 und Leiterbahn 2 herstellen. Sowohl der Chip als auch die Leiterbahn bilden Kontaktflächen, die verbunden werden sollen.

Auf das Substrat 1 mit der Leiterbahn 2 wird jetzt nach Figur 1a eine Maske 4 gelegt. Diese Maske 4 besteht aus einer Eisen-Nickel-Legierung (beispielsweise Invar) und weist an der Stelle ein Loch 4a auf, wo später der Aluminiumdraht auf die Leiterbahn 2 gebondet wird.

In einer nicht gezeigten Anlage für physikalisch-chemische Metalldampfabscheidung wird nach Figur 1a diese Maske 4 durch Dünnfilmtechnik bedampft, sodaß sich durch das Loch 4a in der Maske 4 eine leitende Metallschicht (beispielsweise Nickel oder Titan) auf die Leiterbahn 2 niederschlägt (siehe Figur 1b). Diese aufgedampfte Metallschicht dient als Diffusionssperre 5 zwischen dem Gold der Leiterbahn und dem Aluminium des Verbindungsdrahtes 7. Die Maske 4 wurde in der Figur 1b weggelassen.

Um eine gute elektrische Verbindung zwischen Draht und Leiterbahn herzustellen, wird in einem weiteren Aufdampfungsvorgang auf die Diffusionssperre 5 eine Metallschicht 6 mit den gleichen oder ähnlichen Werkstoffmerkmalen wie der Bonddraht 7 aufgebracht (siehe Figur 1b). Im vorliegenden Fall besteht die zusätzliche Metallschicht aus Aluminium. Jetzt kann durch Ultraschallverschweißung eine sichere Verbindung zwischen dem Bonddraht 7 und der aufgedampften Aluminiumschicht 6 hergestellt werden (siehe Figur 1c).

Erfindungsgemäß dient also ein aufgebrachtes Metall 5 als Diffusionssperre zwischen Leiterbahn 2 und Verbindungsdraht 7. Dieses aufgebrachte Metall ist abhängig von den verwendeten Metallen der Leiterbahn bzw. des Verbindungsdrahtes. Bei Leiterbahnen aus Gold werden beispielsweise Nickel oder Titan und bei Leiterbahnen aus Silber oder Palladium andere Diffusionssperrschichten aufgebracht. Generell werden aber bei diesem Verfahren hybride Dickfilmschaltkreise dadurch vor Korrosion geschützt, daß man mit Hilfe der Dünnfilmtechnik die Kontaktierungsstellen bedampft und so ein Diffusionssperrmaterial aufbringt.

Ein weiteres Verfahren zum Bonden eines Aluminiumdrahtes an eine Leiterbahn wird in den Figuren 2a, 2b gezeigt.

Das Bonden erfolgt normalerweise im Ultraschall-Schweißverfahren. Dabei wird ein Diffusionsschweißvorgang dadurch ausgelöst, daß durch schnelles Reiben (Bewegungsfrequenz mehrere kHz) und die dabei auftretende Reibenergie eine Verbindung erfolgt.

Nach Figur 2a wird ein Verbindungsdraht 8 in ein nicht gezeigtes Ultraschallschweißgerät eingespannt und zum Zwecke der Kontaktierung an die Leiterbahn 2 geführt. Die Bezeichnungen der gleichen Teile erfolgt sinngemäß nach den Figuren 1a bis 1c. Die Leiterbahn 2 ist wieder aus Gold und der Verbindungsdraht 8 aus Aluminium.

Erfindungsgemäß ist der gesamte Verbindungsdraht 8 jetzt zusätzlich von einer Nickelschicht 9 umhüllt (siehe Figur 2b). Verfahren zum Aufbringen einer zusätzlichen Metallschicht auf einen Draht sind bekannt und sollen hier nicht näher erläutert werden. So etwas erfolgt beispielsweise durch sputtern, CVD oder galvanisches Aufbringen.

Gemäß Figur 2a wird der speziell vorbereitete Aluminiumdraht 8, 9 durch das Scheißgerät in Pfeilrichtung über die Leiterbahn 2 geführt. Bei diesem Vorgang wird das Nickel 9 der Drahtumhüllung in die Goldoberfläche der Leiterbahn eingerieben und bildet die Diffusionssperrschicht 5. Das Aluminium des Verbindungsdrahtes 8 bildet sodann durch den Ultraschallschweißvorgang eine innige Verbindung über die Diffusionsschicht 5 mit der Leiterbahn 2. Hierbei wird also die Diffusionssperrschicht direkt auf den Bonddraht 8 als eine ganzflächige Ummantelung 9 aufgebracht und beim anschließenden Schweißvorgang in die Leiterbahn 2 diffundiert.

Dieses Verfahren ist einfacher, schneller und preisgünstiger gegenüber dem Maskenverfahren. Beiden Verfahren ist aber gemeinsam, daß vor dem eigentlichen Löt-oder Schweißvorgang eine Diffusionssperrschicht aufgetragen wird. Diese Sperrschicht besteht vorzugsweise aus den Metallen Nickel, Nickelchrom oder Titan.

Die einzelnen Verfahrensschritte sind noch einmal kurz zusammengefäßt:

Bei dem Maskenverfahren nach den Figuren 1a bis 1c wird eine Maske mit definierten Ausparungen über die Leiterbahn 2 gelegt. Dann wird die Maske bedampft und dadurch eine metallische Sperrschicht aufgetragen. Danach wird die Maske mit einer weiteren Kontaktschicht 6 mit gleichen/ähnlichen Verhalten wie der Bonddraht bedampft. Zum Schluß wird die Verschweißung des Bonddrahtes 7 mit der Kontaktschicht 6 und damit der Leiterbahn 2 vorgenommen.

Beim Verfahren nach den Figuren 2a, 2b wird ein bereits bedampfter Bonddraht 8 verwendet. Beim Ultraschallverschweißen des Bonddrahtes diffundiert die bedampfte Schicht 9 des Bonddrahtes 8 in die Leiterbahn 2 und bildet eine Sperrschicht 5. Anschließend wird der Schweißvorgang zwischen Bonddraht 8 und Leiterbahn 2 fortgesetzt.

## Ansprüche

1. Verfahren zur Herstellung einer Verbindung zwischen einem Bonddraht und einer Kontaktfläche bei hybriden Dickschicht-Schaltkreisen, <u>dadurch gekennzeichnet,</u> daß vor dem Bonden des Drahtes (7, 8) an der Kontaktfläche (2, 3) eine metallische Diffusionssperrschicht (5) hergstellt wird, die eine Korrosion der Verbindungsstelle verhindert.

2. Verfahren nach Anspruch 1, dadurch gekennzeichnet, daß die Diffusionssperrschicht (5) durch physikalisch-chemische Metalldampfabscheidung einer Metallschicht auf die Kontaktflächen (2, 3) entsteht.

3. Verfahren nach Anspruch 1, dadurch gekennzeichnet, daß die Diffusionssperrschicht (5) durch Verschweißen eines ganzflächig mit einer Sperrschicht (9) ummantelten Bonddrahtes (8) entsteht.

4. Verfahren nach Anspruch 2, dadurch gekennzeichnet, daß die physikalisch-chemische Metalldampfabscheidung über eine an der Kontaktfläche (4a) strukturierte Maske (4) erfolgt und anschließend über die Maske (4) eine weitere Metallschicht (6) mit gleichen oder ähnlichen Werkstoffmerkmalen wie der Bonddraht (7) aufgetragen wird.

Fig.1a

Fig.1b

Fig.1c

Fig.2a

Fig.2b